Europäisches Patentamt

European Patent Office

Office européen des brevets

(19)

(11) EP 0 969 593 A1

(12) **EUROPEAN PATENT APPLICATION**

(43) Date of publication:
05.01.2000 Bulletin 2000/01

(51) Int. Cl.$^7$: **H03F 1/02**, H03F 3/50

(21) Application number: **99112770.5**

(22) Date of filing: **01.07.1999**

(84) Designated Contracting States:
**AT BE CH CY DE DK ES FI FR GB GR IE IT LI LU
MC NL PT SE**
Designated Extension States:
**AL LT LV MK RO SI**

(30) Priority: **02.07.1998 JP 18748598**

(71) Applicant: **Rohm Co., Ltd.
Kyoto-shi Kyoto 615-8585 (JP)**

(72) Inventor: **Ohama, Shigeji
Kyoto 615-8585 (JP)**

(74) Representative:
**Reinhard - Skuhra - Weise & Partner
Postfach 44 01 51
80750 München (DE)**

(54) **Signal processor**

(57)     A signal processor has a signal amplifier circuit for amplifying an input signal, a power source terminal for having a source voltage applied thereto and a voltage control circuit for supplying a higher voltage than the source voltage to the signal amplifier circuit according to the input signal. The voltage control circuit includes a diode inserted between the power source terminal and the power source line for the signal amplifier circuit, another amplifier circuit for amplifying the input signal, and a capacitor inserted between the output side of this control amplifier circuit and the power source line of the signal amplifying circuit. By thus controlling the voltage supplied to the signal amplifier circuit, it is possible to increase the dynamic range of signal output without increasing the source voltage

Fig. 1

**Description**

Background of the Invention

This invention relates to a signal processing device, or a signal processor, adapted to output a signal after effecting a specified process on an inputted signal.

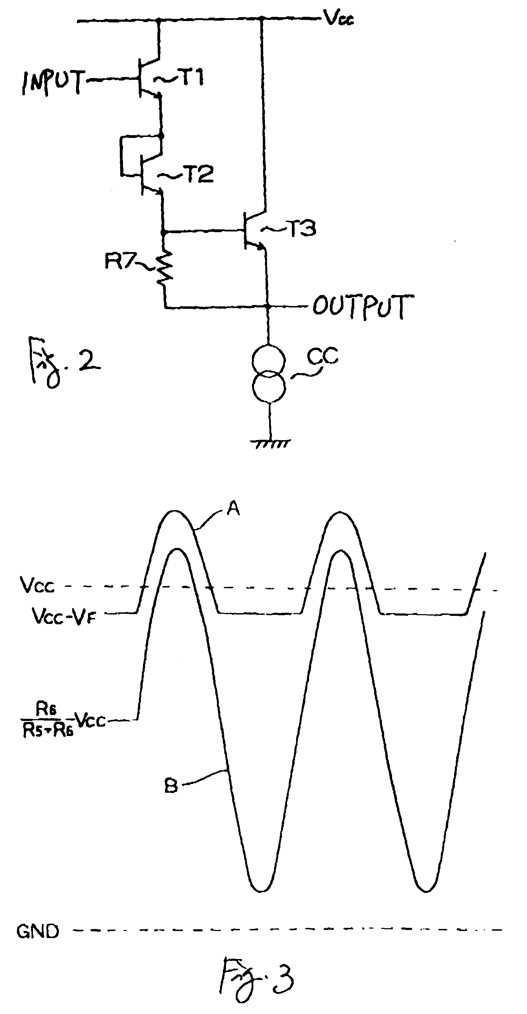

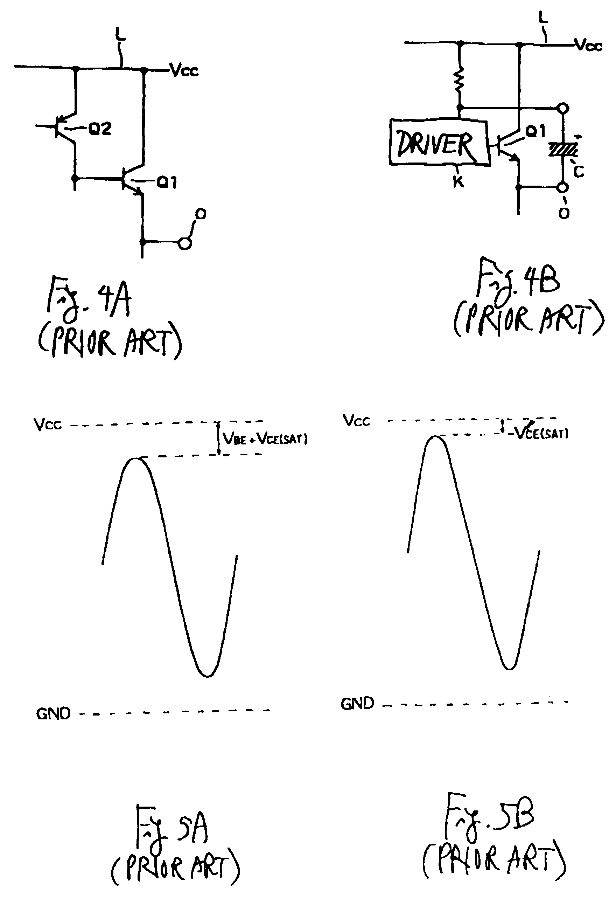

In general, a final-stage power amplifier circuit is formed as shown in Fig. 4A by connecting the base terminal of an upside NPN transistor $Q_1$ to a power source line L through a PNP transistor $Q_2$ serving as the active load of a grounded emitter amplifier circuit, a source voltage $V_{CC}$ being supplied to the power source line L from outside. Thus, the highest voltage that can be obtained at its output terminal is $V_{CC}-V_{BE}-V_{CE(Sat)}$ where $V_{BE}$ is the voltage between the base and the emitter of the upside transistor $Q_1$, and $V_{CE(Sat)}$ is the saturated voltage between the collector and the emitter of the PNP transistor $Q_2$. The residual voltage of the upside transistor $Q_1$ is therefore $V_{BE}-V_{CE(Sat)}$.

In order to reduce this residual voltage, a capacitor C may be inserted between a driver circuit K for the upside transistor $Q_1$ and the output terminal O, as shown in Fig. 4B, such that the base voltage of the upside transistor $Q_1$ is raised by bootstrapping as the output voltage increases and that the residual voltage of the upside transistor $Q_1$ will be reduced to the level of the saturated voltage between the collector and the emitter of the upside transistor $Q_1$ ($V'_{CE(Sat)}$), as shown in Fig. 5B.

With the recent trend to digitalize signal sources, higher-quality S/N characteristics are coming to be required. For this purpose, it is necessary to increase the output dynamic range of signal as much as possible. Particularly large dynamic ranges are required especially for applications to car audio systems because there are many sources of noise around.

With a prior art signal processor, as explained above, however, the upper limit of the output voltage could not be made greater than the source voltage, although there may be some difference in the residual voltage of the upside transistor. In summary, the dynamic range could not be increased unless the source voltage itself was increased.

Summary of the Invention

It is therefore an object of this invention to provide a signal processor capable of increasing the dynamic range and improving the S/N characteristic without increasing the source voltage.

A signal processor embodying this invention, with which the above and other objects can be accomplished may be characterized simply as comprising a signal amplifier circuit for amplifying an input signal, a power source terminal for having a source voltage applied thereto and a voltage control circuit for supplying a higher voltage than the source voltage to the signal amplifier circuit according to the input signal. With a signal processor thus structured, it is possible to raise the maximum output voltage from the signal amplifying circuit without increasing the source voltage. Such a voltage control circuit may include a unidirectionally conductive element, such as a diode, inserted between the power source terminal and the power source line for the signal amplifier circuit, another amplifier circuit ("the control amplifier circuit") for amplifying the input signal and outputting an amplified signal, and a capacitor inserted between the output side of this control amplifier circuit and the power source line of the signal amplifying circuit.

Brief Description of the Drawings:

The accompanying drawings, which are incorporated in and form a part of this specification, illustrate an embodiment of the invention and, together with the description, serve to explain the principles of the invention. In the drawings:

Fig. 1 is a block diagram of a signal processor embodying this invention;
Fig. 2 is a circuit diagram of each of the level shifters of Fig. 1;
Fig. 3 is a wave diagram showing the waveforms of voltages appearing in the signal processor of Fig. 1;
Figs. 4A and 4B are circuit diagrams of output portions of prior art signal processing circuits; and
Figs. 5A and 5B are wave diagrams for showing the signal output dynamic ranges of the prior art signal processing circuits of Figs. 4A and 4B.

Detailed Description of the Invention

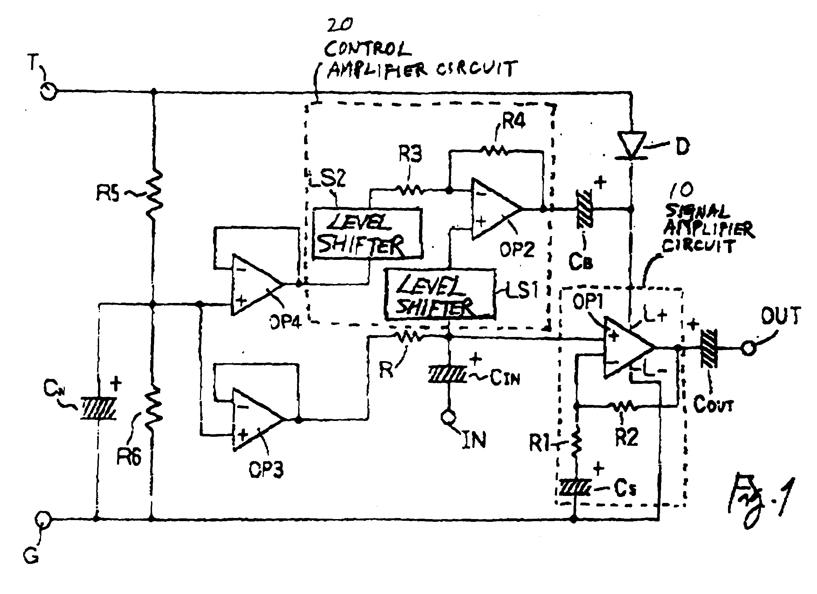

The invention is explained next by way of its embodiment with reference to the drawings. Fig. 1 is a block diagram of a signal processor according to this invention, comprising operational amplifiers OP1, OP2, OP3 and OP4, as well as level shifters LS1 and LS2, the non-inversion input terminal (+) of operational amplifier OP1 being connected to the output terminal of operational amplifier OP3 through resistor R and also to a signal input terminal IN through an input coupling capacitor $C_{IN}$. The inversion input terminal (-) of operational amplifier OP1 is connected to a grounding terminal G through resistor $R_1$ and capacitor $C_S$. The output terminal of operational amplifier OP1 is connected to an output terminal OUT and also to the inversion input terminal (-) of operational amplifier OP1 through resistor $R_2$. The circuit consisting of operational amplifier OP1, resistors R1 and R2 and capacitor $C_S$, as shown enclosed inside a broken line in Fig. 1, is herein referred to as "the signal amplifier circuit".

Like the non-inversion input terminal (+) of operational amplifier OP1, the input side of level shifter LS1 is also connected to the output terminal of operational amplifier OP3 through resistor R and also to the signal input terminal IN through the input coupling capacitor $C_{IN}$. The output side of level shifter LS1. is connected to the non-inversion input terminal (+) of operational amplifier OP2.

The input side of level shifter LS2 is connected to the output terminal of operational amplifier OP4. The inversion input terminal (-) of operational amplifier OP2 is connected to the output side of level shifter LS2 through resistor R3. The output terminal of operational amplifier OP2 is connected to the inversion input terminal (-) of operational amplifier OP2 thought resistor R4. The circuit consisting of operational amplifier OP2, resistors R3 and R4 and level shifters LS1 and LS2, as shown enclosed inside another broken line in Fig. 1, is herein referred to as "the control amplifier circuit".

Level shifters LS1 and LS2 are each structured as shown in Fig. 2, comprising transistors T1, T2 and T3 and a constant-current circuit CC. The collector of transistor T1 is connected to the source voltage $V_{CC}$. The collector of diode-connected transistor T2 is connected to the emitter of transistor T1. The current output side of the constant-current circuit CC is grounded. The base, the collector and the emitter of transistor T3 are respectively connected to the emitter of transistor T2, the source voltage $V_{CC}$ and the current input side of the constant-current circuit CC. The base and the emitter of transistor T3 are connected by resistor R7. If the base-emitter voltage of transistors T1, T2 and T3 is $V_{BE}$, the voltage inputted to the base of transistor T1 is reduced by $3V_{BE}$ as it is outputted from the emitter of transistor T3.

The output terminal and the inversion input terminal (-) of operational amplifier OP3 are connected to each other. The output terminal and the inversion input terminal (-) of operational amplifier OP4 are also connected to each other. Resistors R5 and R6 are connected in series between a source terminal T (where source voltage $V_{CC}$ is applied) and the ground terminal G, and the junction between resistors R5 and R6 is connected to the non-inversion input terminals (+) of operational amplifiers OP3 and OP4. This junction is also connected to a capacitor $C_N$ for eliminating noise.

The power source line L+ on the "plus side" of operational amplifier OP1 is connected both to the source terminal T through a diode D (serving as a unidirectionally conductive element) and to the output terminal of operational amplifier OP2 through capacitor $C_B$. The power source line L- on the "minus side" of operational amplifier OP1 is connected to the grounding terminal G. Although not shown in Fig. 1 for the sake of simplicity, the power source lines on the "plus side" or operational amplifiers OP2, OP3 and OP3 are all connected to the source terminal and their power source lines on the "minus" side are all connected to the grounding terminal G.

If this circuit is to be formed as a semiconductor integrated circuit, the capacitors $C_{IN}$, $C_{OUT}$, $C_S$, $C_N$ and $C_B$ will be generally attached externally. Resistors R1 and R2 for determining the signal amplification by operational amplifier OP1 are also generally provided externally.

Let the resistance values of resistors Rk (k=1-6) be $R_k$. When there is no signal being inputted at the input terminal IN, the output voltage of operational amplifier OP2 becomes $V_{CC}R_6/(R_5 + R_6) - 3V_{BE}$. If the voltage drop in the forward direction of the diode D is $V_F$, the values of various parameters are set such that $V_{CC}-V_F > V_{CC}R_6/(R_5 + R_6) - 3V_{BE}$, such that a current will flow in from the diode D to charge the capacitor $C_B$. If $V_{CC}$ = 9V, $R_5$ = 6.8kΩ, $R_6$ = 24kΩ, $V_{BE}$ = 0.6V and $V_F$ = 0.6V, for example, $V_{CC}-V_F$ = 8.4V and $V_{CC}R_6/(R_5 + R_6)-3V_{BE}$ - 5.2V .

At the time of no signal, operational amplifier OP1 is operating at voltage $V_{CC}-V_F$, the capacitor $C_S$ is charged and the output voltage at the output terminal OUT is $V_{CC}R_6/(R_5 + R_6)$. If $V_{CC}$ = 9V, $R_5$ = 6.8kΩ and $R_6$ = 24kΩ, as above, $V_{CC}R_6/(R_5 + R_6)$ = 7V .

If a sine wave signal is inputted at the input terminal IN under this condition, a signal which has been amplified by a factor of $(R_3 + R_4)/R_3$ will appear on the output terminal of operational amplifier OP2. Thus, the voltage on the power source line L+ on the plus side of operational amplifier OP1 is pushed up in the positive half-wave region above $V_{CC}-V_F$ by the charged voltage of capacitor $C_B$, as shown by curve "A" in Fig. 3. If $V_{CC}$ = 9V, $R_3$ = 22kΩ, $R_4$ = 33kΩ, $R_5$ = 6.8kΩ and $R_6$ = 24kΩ and if the amplitude of the input signal at the input terminal IN is 1V, for example, $(R_3 + R_4)/R_3$ = 2.5 and the maximum voltage on the power source line L+ on the positive side of operation amplifier OP1 becomes 8.4 + 2.5 = 10.9V. In the negative half-wave regions, on the other hand, it remains at $V_{CC}-V_F$ due to the diode D.

In summary, the voltage supplied to the power source line L+ can be raised above $V_{CC}-V_F$ and it can be raised even above $V_{CC}$ by appropriately setting the value of $(R_3 + R_4)/R_3$. In summary, the upper limit of the output voltage of operational amplifier OP1 can be raised without increasing the source voltage $V_{CC}$.

Although the inputted signal appears amplified by the factor of $(R_1 + R_2)/R_1$ on the output terminal of operational amplifier OP1, since the signals appearing on the output terminal of operational amplifier OP1 and the output terminal of operational amplifier OP2 are in phase, the output dynamic range of signal output can be made large without distortions, as shown by curve "B" in Fig. 3, and the S/N characteristic can be improved without making the source voltage large due to the DC level on the input terminal of operational amplifier OP1 (that is, $V_{CC}R_6/(R_5 + R_6)$) and the relationship between the values of $(R_1 + R_2)/R_1$ and $(R_3 + R_4)/R_3$. If $V_{CC}$ = 9V, $R_1$ = 22kΩ, $R_2$ = 33kΩ, $R_3$ = 22kΩ, $R_4$ = 33kΩ, $R_5$ = 6.8kΩ and $R_6$ = 24kΩ, for example, $V_{CC}R_6/(R_5 + R_6) \simeq 7V$ and $(R_1 + R_2)/R_1$ = 2.5 . If the amplitude of the input signal at the input terminal IN is 1V, for example, the maximum voltage on the output side of operational amplifier OP1 becomes approximately equal to 9.5V. If the parameters are set as above, the maximum voltage on the source line L+ on the plus side of operational amplifier OP1 is 10.9V, as mentioned above, and is higher than the output voltage of operational amplifier OP1.

In summary, the output dynamic range of signals can be made larger and the S/N characteristic can be improved according to this invention without increasing the source voltage. Thus, this invention is very useful when incorporated in an apparatus such as car audio sets, car cassette players and other portable devices which require improved S/N characteristics in an environment of limited source voltage.

A signal processor ham a signal amplifier circuit for amplifying an input signal, a power source terminal for having a source voltage applied thereto and a voltage control circuit for supplying a higher voltage than the source voltage to the signal amplifier circuit according to the input signal. The voltage control circuit includes a diode inserted between the power source terminal and the power source line for the signal amplifier circuit, another amplifier circuit for amplifying the input signal, and a capacitor inserted between the output side of this control amplifier circuit and the power source line of the signal amplifying circuit. By thus controlling the voltage supplied to the signal amplifier circuit, it is possible to increase the dynamic range of signal output without increasing the source voltage

**Claims**

1. A signal processor comprising:

   a signal amplifier circuit (10) for amplifying and input signal;
   a power source terminal (T) for having a source voltage applied thereto;
   a power source line (L+) for supplying power to said signal amplifier circuit (10);
   a voltage control circuit for supplying a higher voltage than said source voltage to said signal amplifier circuit (10) through said power source line (L4) according to said input signal;
   said voltage control circuit comprising a control amplifier circuit (20) having an output terminal for amplifying said input signal and outputting an amplified signal at said output terminal.

2. A signal processor according to claim 1 comprising a uni-directionally conductive element (D) inserted between said power source terminal (T) and said power source line (L+).

3. A signal processor according to claim 1 or 2 comprising a capacitor ($C_B$)between said output terminal of said control amplifier circuit (20) and said power source line (L+).

4. A signal processor according to at least one of the preceding claims, wherein said signal amplifier circuit (10) includes an operational amplifier (OP1) having an output terminal and an inversion input terminal, wherein said output terminal and said inversion input terminal are connected through a resistor (R2).

5. A signal processor according to claim 4, wherein said inversion input terminal is connected to a ground terminal (G) through a capacitor ($C_S$) and a resistor (R1) which are connected in series.

6. A signal processor according to at least one of the preceding claims, wherein said input signal is applied to said operational amplifier (OP1) through a non-inversion terminal.

7. A signal processor according to at least one of the preceding claims, wherein said control amplifier circuit (20) comprises an operational amplifier (OP1), a first level shifter (LS1) and a second level shifter (LS2).

8. A signal processor according to claim 7, wherein said operational amplifier (OP2) comprises an output terminal and an inversion input terminal which are connected through a resistor (R4).

9. A signal processor according to claim 7 or 8, wherein said control amplifier circuit (20) comprises a non-inversion input terminal being connected to said first level shifter (LS1).

10. A signal processor according to at least one of the claims 7 to 9, wherein said inversion input terminal is connected to said second level shifter (LS2) through a resistor (R3).

11. A signal processor according to at least one of the claims 7 to 10, wherein said input signal is received by said operational amplifier (OP2) through said first level shifter (LS1) and said non-inversion input terminal.

Fig.1

Fig. 2

Fig. 3

Fig. 4A
(PRIOR ART)

Fig. 4B
(PRIOR ART)

Fig. 5A
(PRIOR ART)

Fig. 5B
(PRIOR ART)

**European Patent Office**

# EUROPEAN SEARCH REPORT

Application Number

EP 99 11 2770

## DOCUMENTS CONSIDERED TO BE RELEVANT

| Category | Citation of document with indication, where appropriate, of relevant passages | Relevant to claim | CLASSIFICATION OF THE APPLICATION |
|---|---|---|---|
| X | GB 2 181 916 A (SGS MICROELETTRONICA SPA) 29 April 1987 (1987-04-29) * the whole document * | 1-3 | H03F1/02 H03F3/50 |
| A | US 4 217 556 A (ITO HIDEO ET AL) 12 August 1980 (1980-08-12) * the whole document * | 4-6,8,9, 11 | |
| A | P. GARDE: "SCHEMES FOR INCREASED OUTPUT-VOLTAGE SWING FROM OPERATIONAL AMPLIFIERS" ELECTRONICS LETTERS, vol. 13, no. 4, 17 February 1977 (1977-02-17), pages 111-112, XP002114051 STEVENAGE GB * page 111 - page 112; figure 1 * | 7,11 | |

TECHNICAL FIELDS SEARCHED

H03F

The present search report has been drawn up for all claims

| Place of search | Date of completion of the search | Examiner |
|---|---|---|
| THE HAGUE | 2 September 1999 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 99 11 2770

This annex lists the patent family members relating to the patent documents cited in the above-mentioned European search report.
The members are as contained in the European Patent Office EDP file on
The European Patent Office is in no way liable for these particulars which are merely given for the purpose of information.

02-09-1999

| Patent document cited in search report | | Publication date | Patent family member(s) | | Publication date |
|---|---|---|---|---|---|
| GB 2181916 | A | 29-04-1987 | IT | 1200794 B | 27-01-1989 |
| | | | DE | 3634979 A | 16-04-1987 |
| | | | FR | 2589649 A | 07-05-1987 |
| | | | JP | 62095005 A | 01-05-1987 |
| | | | NL | 8602587 A,B, | 18-05-1987 |
| | | | US | 4752747 A | 21-06-1988 |
| US 4217556 | A | 12-08-1980 | JP | 54080053 A | 26-06-1979 |

EPO FORM P0459

For more details about this annex : see Official Journal of the European Patent Office, No. 12/82